# EUROPEAN PATENT SPECIFICATION

(11) **EP 2 056 325 B1**
(45) Date of publication and mention of the grant of the patent: **07.09.2011**
(21) Application number: 08167469.9
(22) Date of filing: 24.10.2008
(51) Int. Cl.: H01H 59/00

(54) **System and method for avoiding contact stiction in micro-electromechanical system based switch**
System und Verfahren zur Vermeidung von Kontakthaftreibung in einem Schalter auf Basis eines mikroelektromechanischen Systems
Système et procédé pour éviter le frottement de contact dans un commutateur basé sur un système micro-électromécanique

(30) Priority: 31.10.2007 US 931353
(43) Date of publication of application: 06.05.2009
(73) Proprietor: General Electric Company, Schenectady, NY 12345 (US)
(72) Inventor: O'Brien, Kathleen Ann, Albany, NY 12210 (US); Subramanian, Kanakasabapathi, Clifton Park, NY 12065 (US); Hedges, Nicole Christine Reeves, Albany, NY 12203 (US); Idelchik, Michael Solomon, Niskayuna, NY 12309 (US); Schelenz, Owen Jannis, Schenectady, NY 12305 (US)
(74) Representative: Illingworth-Law, William Illingworth

(56) References cited:
- WO-A-00/39915
- US-A- 5 822 170

## Description

### BACKGROUND OF THE INVENTION

Embodiments of the invention relate generally to electrical circuitry, and, more particularly, to micro-electromechanical system (MEMS) based switching devices, and, even more particularly, to a system and method for avoiding a tendency of switch contacts to stick to one another without interrupting system operation.

A circuit breaker is an electrical device designed to protect electrical equipment from damage caused by faults in the circuit. Traditionally, most conventional circuit breakers include bulky electromechanical switches. Unfortunately, these conventional circuit breakers are large in size thereby necessitating use of a large force to activate the switching mechanism. Additionally, the switches of these circuit breakers generally operate at relatively slow speeds. Furthermore, these circuit breakers are disadvantageously complex to build and thus expensive to fabricate. In addition, when contacts of the switching mechanism in conventional circuit breakers are physically separated, an arc is typically formed there between which continues to carry current until the current in the circuit ceases. Moreover, energy associated with the arc may seriously damage the contacts and/or present a bum hazard to personnel.

As an alternative to slow electromechanical switches, it is known to use relatively fast solid-state switches in high speed switching applications. As will be appreciated, these solid-state switches switch between a conducting state and a non-conducting state through controlled application of a voltage or bias. For example, by reverse biasing a solid-state switch, the switch may be transitioned into a non-conducting state. However, since solid-state switches do not create a physical gap between contacts when they are switched into a non-conducting state, they experience leakage current. Furthermore, due to internal resistances, when solid-state switches operate in a conducting state, they experience a voltage drop. Both the voltage drop and leakage current contribute to the dissipation of excess power under normal operating circumstances, which may be detrimental to switch performance and life.

MEMS switching devices can offer notable advantages over traditional electromechanical switches and solid-state switches. It has been observed, however, that MEMS switching devices can exhibit contact stiction or a tendency of contacts of the switch to stick to one another (e.g., the switch contacts can remain closed when commanded to open, or can exhibit an unacceptable time delay in opening when commanded to open) after having been closed for a relatively long period of time, which may vary depending on the characteristics of a given switch.

It is known that contact stiction can occur, for example, due to metal diffusion over time of contact materials. This stiction phenomenon is likely to occur in operational situations when the switches are used in applications - such as circuit breaker applications - where the normal operating state of the switch is closed. This can lead to degraded performance when the switching device takes longer to open than a specified switching time, and can even lead to a failure when the switch fails to open at all. Accordingly, it is desirable to provide a system and/or control techniques for reducing or avoiding this tendency to stick of MEMS switching devices and thus incrementally contribute to the overall reliability of the system and/or application in which the switch is used. Document WO 00/39915 discloses a device according to the preamble of claim 1.

### BRIEF DESCRIPTION OF THE INVENTION

According to a first aspect of the invention, there is provided a system comprising micro-electromechanical system switching circuitry comprising a plurality of micro-electromechanical switches, wherein said plurality of micro-electromechanical switches generally operates in a closed switching condition during system operation; and a controller coupled to the electromechanical switching circuitry, the controller configured to actuate at least one of said micro-electromechanical switches to a temporary open switching condition while a remainder of micro-electromechanical switches remains in the closed switching condition to conduct a load circuit current and avoid interrupting system operation, said temporary open switching condition of the switch useful to avoid a tendency of switch contacts to stick to one another, in which the controller is further configured to perform a switching algorithm configured to actuate at least one distinct micro-electromechanical switch of said plurality of micro-electromechanical switches to the temporary open switching condition, wherein said at least one distinct switch comprises a switch not previously having been actuated over a predefined period of time to the temporary open switching condition, and, while actuation of said at least one distinct micro-electromechanical switch to the temporary open switching condition occurs, another remainder of the micro-electromechanical switches remains in the closed switching condition to avoid interrupting system operation.

The controller may be further configured to selectively execute the switching algorithm over said predefined period of time so that eventually each of said plurality of switches is actuated at least once to the temporary open switching condition over the period of time, thereby ensuring each switch of the micro-electromechanical system switching circuitry has been actuated to avoid the tendency of respective switch contacts to stick to one another.

The system may further comprise circuitry coupled to the micro-electromechanical system switching circuitry to avoid current flow through the contacts of said at least one of said micro-electromechanical switches as the switch transitions to enter the temporary open switching condition from the closed switching condition.

The circuitry may be further configured to collapse a voltage level across the contacts of said at least one of said micro-electromechanical switches as the switch returns out of the temporary open switching condition to the closed switching condition.

The system may further comprising circuitry configured to synchronize the occurrence of the temporary open switching condition of said at least one of said micro-electromechanical switches with the occurrence of a zero crossing of at least one of the following: an alternating source voltage and an alternating load circuit current.

According to a second aspect of the invention, there is provided a method for actuating micro-electromechanical system switching circuitry to avoid a tendency of switch contacts to stick to one another, said micro-electromechanical system switching circuitry comprising a plurality of micro-electromechanical switches, wherein said plurality of micro-electromechanical switches generally operates in a closed switching condition during system operation, the method comprising actuating at least one of said micro-electromechanical switches to a temporary open switching condition while a remainder of micro-electromechanical switches remains in the closed switching condition to conduct a load circuit current and avoid interrupting system operation, said temporary open switching condition of the switch useful to avoida tendecy of switch contacts to stick to one another.

The method may further comprise actuating at least one distinct micro-electromechanical switch of said plurality of micro-electromechanical switches to the temporary open switching condition.

### BRIEF DESCRIPTION OF THE DRAWINGS

There follow a detailed description of embodiments of the invention by way of example only and with reference to the accompanying drawings, in which:
FIG. 1 is a block diagram of an exemplary MEMS based switching system, in accordance with aspects of the present technique;
FIG. 2 illustrates example circuit details in connection with the MEMS based switching system of FIG. 1;
FIG. 3 is a block diagram of an exemplary MEMS based switching system, as may include an over current protection circuit;
FIG. 4 is schematic diagram illustrating circuit details in connection with the MEMS based switching system of FIG. 3;
FIG. 5 is a block diagram of an exemplary MEMS based switching system, as may include zero crossings detection circuitry;
FIG. 6 illustrates plots of example waveforms as may develop in the exemplary MEMS based switching system of FIGs. 3 and 4 as a switch is being set to a temporary open condition to avoid contact stiction; and
FIG. 7 illustrates plots of example waveforms as may develop in the event zero-crossing detection circuitry is utilized with the micro-electromechanical system switching circuitry.

### DETAILED DESCRIPTION OF THE INVENTION

In accordance with one or more embodiments of the present invention, a system including micro-electromechanical system (MEMS) switching circuitry will be described herein. In the following detailed description, numerous specific details are set forth in order to provide a thorough understanding of various embodiments of the present invention. However, those skilled in the art will understand that embodiments of the present invention may be practiced without these specific details, that the present invention is not limited to the depicted embodiments, and that the present invention may be practiced in a variety of alternative embodiments. In other instances, well known methods, procedures, and components have not been described in detail.

Furthermore, various operations may be described as multiple discrete steps performed in a manner that is helpful for understanding embodiments of the present invention. However, the order of description should not be construed as to imply neither that these operations need to be performed in the order they are presented, nor that they are even order dependent. Moreover, repeated usage of the phrase "in one embodiment" does not necessarily refer to the same embodiment, although it may. Lastly, the terms "comprising", "including", "having", and the like, as used in the present application, are intended to be synonymous unless otherwise indicated.

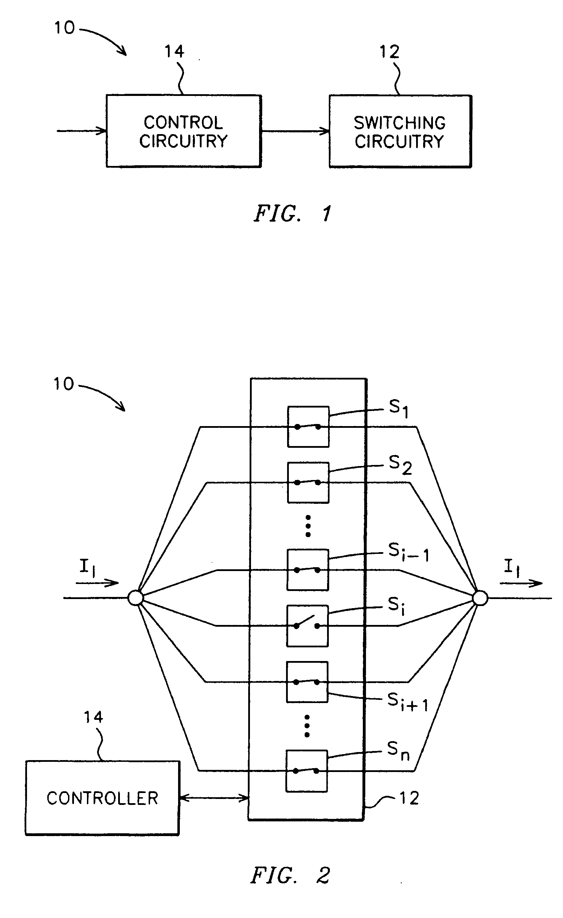

FIG. 1 illustrates a block diagram of an example embodiment of a micro-electromechanical system (MEMS)-based switching system 10, in accordance with aspects of the present invention. Presently, MEMS generally refer to micron-scale structures that for example can integrate a multiplicity of functionally distinct elements, e.g., mechanical elements, electromechanical elements, sensors, actuators, and electronics, on one or more substrates through micro-fabrication technology. It is contemplated, however, that many techniques and structures presently available in MEMS devices will in just a few years be available via nanotechnology-based devices, e.g., structures that may be smaller than 100 nanometers in size. Accordingly, even though example embodiments described throughout this document may refer to MEMS-based switching system, it is submitted that the inventive aspects of the present invention should be broadly construed and should not be limited to micron-sized devices.

As illustrated in FIG. 1, MEMS based switching system 10 includes MEMS based switching circuitry 12. For example, in a circuit breaker application MEMS based switching circuitry 12 may be made up of a plurality of micro-electromechanical switches that generally operates in a closed switching condition to conduct a load circuit current during system operation. Accordingly, such switches may be vulnerable to contact stiction. As further illustrated in FIG. 1, a controller 14 is coupled to MEMS based switching circuitry 12.

As shown in FIG. 2, controller 14 may be configured to actuate at least one of the micro-electromechanical switches (e.g., switch Sᵢ) to a temporary open switching condition while a remainder of micro-electromechanical switches, such as switches S₁, S₂ through Sᵢ₋₁ and Sᵢ₊₁ through Sₙ remain in the closed switching condition to conduct load circuit current (I₁) and avoid interrupting system operation. The inventors of the present invention have recognized that such temporary open switching condition of the switch (e.g., in the order of microseconds) is useful to avoid a tendency of switch contacts to stick to one another. It will be appreciated that the number of switches that may be simulateneoulsy set to the temporary open switching condition need not be constrained to one switch. In one example embodiment this number may be based on the capability of the switches that remain closed to carry the incremental level of load circuit current due to the number of switches set to the temporarry open condition. That is, the switches that remain closed would carry the load current they normally carry plus the alluded to incremental level of current due to the number of switches set to the temporary open condition. In the illustrated example, switches S₁, S₂ through Sᵢ₋₁ and Sᵢ₊₁ through Sₙ in combination should be capable of carrying (in addition to the load current they normally carry) the incremental level of load circuit current due to switch Sᵢ being set to the temporarry open condition. It will be appreciated that aspects of the present invention are not limited to parallel circuit arrangements of micro-electromechanical switches since series circuit arrangements or a combination of parallel and series circuit micro-electromechanical switches may equally benefit from aspects of the present invention.

In one example embodiment, controller 14 may be configured to perform a switching algorithm to actuate at least one distinct micro-electromechanical switch of the plurality of micro-electromechanical switches to the temporary open switching condition. Typically, this switch would be a switch not previously having been actuated over a predefined period of time (e.g., in the order of weeks, days, etc.) to the temporary open switching condition. Returning to the illustrated example, if switch Sᵢ₋ has already been set to the temporary open condition over the predefined period of time, then any switch (or switches not yet actuated) should then be set to the temporary open condition. While actuation of such at least one distinct micro-electromechanical switch to the temporary open switching condition occurs, another remainder of the micro-electromechanical switches would remain in the closed switching condition to avoid interrupting system operation. For example, if switches S₁ and S₂ are the switches presently set to the temporary open switching condition, then the remainder of micro-electromechanical switches in the closed switching condition would be switches S₃ (not shown) through Sₙ.

In one example embodiment, controller 14 is configured to selectively execute the switching algorithm over the predefined period of time so that eventually each of the plurality of switches is actuated at least once to the temporary open switching condition over such period of time. The switching algorith would ensure each switch of the micro-electromechanical system switching circuitry has been actuated to avoid the tendency of respective switch contacts to stick to one another.

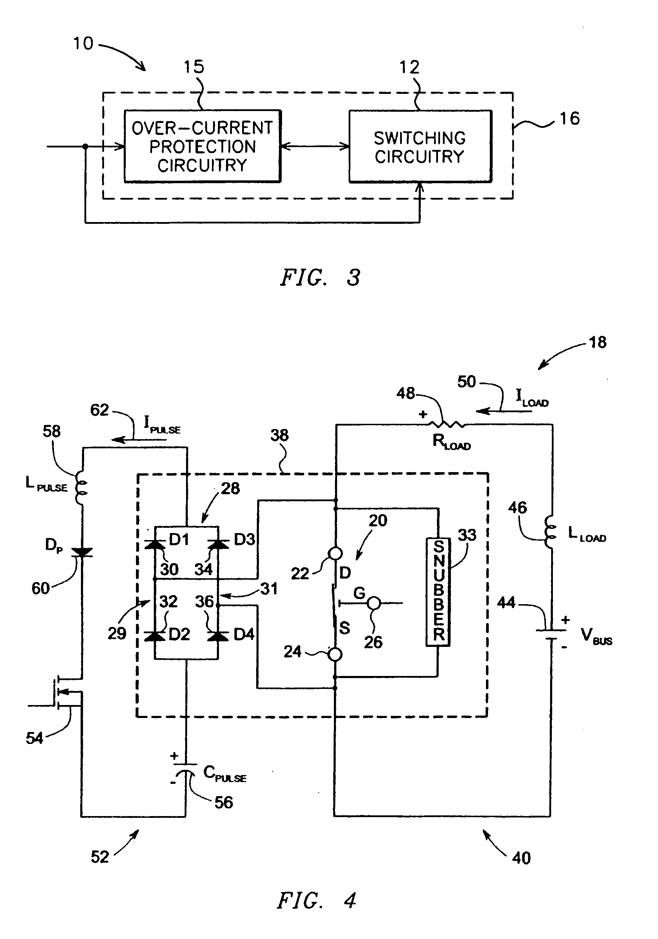

In one example embodiment as illustrated in FIG. 3, circuitry such as over current protection circuitry 15 may be coupled to the micro-electromechanical system switching circuitry. The over current protection circuitry 15 may include a balanced diode bridge and a pulse circuit. Further, the over current protection circuitry 15 may be configured to facilitate suppression of an arc formation between contacts of the MEMS switches. It may be noted that the over current protection circuitry 15 may be configured to facilitate suppression of an arc formation in response to an alternating current (AC) or a direct current (DC).

For readers desirous of background information in connection with suppression of arc formation reference is made to US patent application serial No. 11/314,336 filed on December 20, 2005, (Attorney Docket No. 162711-1). The foregoing application describes high-speed micro-electromechanical system (MEMS) based switching devices including circuitry and pulsing techniques adapted to suppress arc formation between contacts of the micro-electromechanical system. In such an application, arc formation suppression is accomplished by effectively shunting a current flowing through such contacts.

In accordance with further aspects of the present invention, over current protection circuitry 15 may be configured to avoid current flow through the contacts of each of the micro-electromechanical switches being actuated to the temporary open condition. For example, current flow is diverted (e.g., shunted) as each such switch transitions to enter the temporary open switching condition from the closed switching condition. Furthermore, over current protection circuitry 15 may be configured to collapse a voltage level across the contacts of each of the micro-electromechanical switches being actuated to the temporary open condition. For example, the voltage level would cause such a collapse as each such switch returns out of the temporary open switching condition to the closed switching condition.

In certain embodiments, the MEMS based switching circuitry 12 may be integrated in its entirety with the over current protection circuitry 15 in a single package 16, for example. In other embodiments, only certain portions or components of the MEMS based switching circuitry 12 may be integrated with the over current protection circuitry 15.

Generally, MEMS-based switching circuitry should not be closed to a conductive switching state in the presence of a voltage across its switching contacts nor should such circuitry be opened into a non-conductive switching state while passing current through such contacts. One example of a MEMS-compatible switching technique that avoids the foregoing issues may be a pulse-forming technique as described in the foregoing patent application.

Another example of a MEMS-compatible switching technique may be achieved by configuring the switching system to perform soft or point-on-wave switching whereby one or more MEMS switches in the switching circuitry 12 may be closed at a time when the voltage across the switching circuitry 12 is at or very close to zero, and opened at a time when the current through the switching circuitry 12 is at or close to zero. For readers desirous of background information regarding such a technique reference is made to patent application titled "Micro-Electromechanical System Based Soft Switching", US patent application serial No. 11/314,879 filed 12/20/2005, (Attorney Docket No. 162191-1).

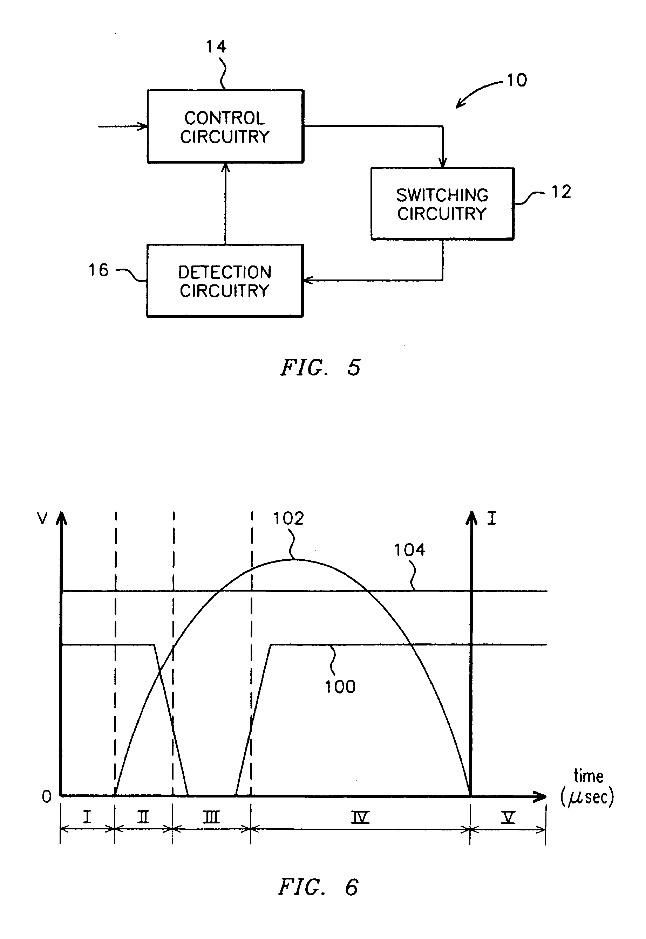

By closing one or more switches at a time when the voltage across the switching circuitry 12 is at or very close to zero, pre-strike arcing can be avoided by keeping the electric field low between the contacts of the one or more MEMS switches as such switches are commanded to a temporary open condition. As alluded to above and illustrated in FIG. 5, controller 14 may be configured to synchronize the opening and closing of the one or more MEMS switches of the switching circuitry 12 with the occurrence of a zero crossing of an alternating source voltage or an alternating load circuit current, as may be detected with a suitable zero-crossing detection circuitry 16.

Turning now to FIG. 4, a schematic diagram 18 of the exemplary MEMS based switching system depicted in FIG. 3 is illustrated in accordance with one example embodiment of over current protection circuitry. In the illustrated embodiment, a first MEMS switch 20 is depicted as having a first contact 22, a second contact 24 and a third contact 26. In one embodiment, the first contact 22 may be configured as a drain, the second contact 24 may be configured as a source and the third contact 26 may be configured as a gate. Furthermore, as illustrated in FIG. 4, a voltage snubber circuit 33 may be coupled in parallel with the MEMS switch 20 and configured to limit voltage overshoot during fast contact separation as will be explained in greater detail hereinafter. In certain embodiments, the snubber circuit 33 may include a snubber capacitor (not shown) coupled in series with a snubber resistor (not shown). The snubber capacitor may facilitate improvement in transient voltage sharing during the sequencing of the opening of the MEMS switch 20. Furthermore, the snubber resistor may suppress any pulse of current generated by the snubber capacitor during closing operation of the MEMS switch 20. In one example embodiment, snubber 33 may comprise one or more types of circuits, e.g., an R/C snubber and/or a solid-state snubber (such as a metal oxide varistor (MOV) or any suitable overvoltage protection circuit, e.g., a rectifier coupled to feed a capacitor. Preferably, the snubber capacitor should be constructed on each die to avoid inductance issues.

In accordance with further aspects of the present technique, a load circuit 40, such an electromotive machine or electric motor, may be coupled in series with the first MEMS switch 20. The load circuit 40 may be connected to a suitable voltage source *V_{BUS}*, such as an alternating voltage (AC) or a direct voltage (DC) 44. In addition, the load circuit 40 may comprise a load inductance 46 *L_{LOAD}*, where the load inductance *L_{LOAD}* 46 is representative of a combined load inductance and a bus inductance viewed by the load circuit 40. The load circuit 40 may also include a load resistance *R_{LOAD}* 48 representative of a combined load resistance viewed by the load circuit 40. Reference numeral 50 is representative of a load circuit current *I_{LOAD}* that may flow through the load circuit 40 and the first MEMS switch 20.

In the illustrated embodiment, a balanced diode bridge 28 is depicted as having a first branch 29 and a second branch 31. As used herein, the term "balanced diode bridge" is used to represent a diode bridge that is configured such that voltage drops across both the first and second branches 29, 31 are substantially equal. The first branch 29 of the balanced diode bridge 28 may include a first diode *D1* 30 and a second diode *D2* 32 coupled together to form a first series circuit. In a similar fashion, the second branch 31 of the balanced diode bridge 28 may include a third diode *D3* 34 and a fourth diode *D4* 36 operatively coupled together to form a second series circuit. It will be appreciated that each of the diode elements in balanced diode bridge 28 may be made up of multiple diodes in parallel rather than just one individual diode. This type of multi-diode arrangement may facilitate resistance reduction in the branches of the diode bridge.

In one embodiment, the first MEMS switch 20 may be coupled in parallel across midpoints of the balanced diode bridge 28. The midpoints of the balanced diode bridge may include a first midpoint located between the first and second diodes 30, 32 and a second midpoint located between the third and fourth diodes 34, 36. Furthermore, the first MEMS switch 20 and the balanced diode bridge 28 may be tightly packaged to facilitate minimization of parasitic inductance caused by the balanced diode bridge 28 and in particular, the connections to the MEMS switch 20. It may be noted that, in accordance with exemplary aspects of the present technique, the first MEMS switch 20 and the balanced diode bridge 28 are positioned relative to one another such that the inherent inductance between the first MEMS switch 20 and the balanced diode bridge 28 produces a L* *di*/*dt* voltage, where L represents the parasitic inductance. The voltage produced may be less than a few percent of the voltage across the drain 22 and source 24 of the MEMS switch 20 when carrying a transfer of the load current to the diode bridge 28 during the MEMS switch 20 turn-off which will be described in greater detail hereinafter. In one embodiment, the first MEMS switch 20 may be integrated with the balanced diode bridge 28 in a single package 38 or optionally, the same die with the intention of minimizing the inductance interconnecting the MEMS switch 20 and the diode bridge 28. By way of example, FIG. 4 illustrates one MEMS switch coupled to the diode bridge. In general, multiple switches in parallel and/or series circuit may be coupled to the diode bridge.

Additionally, the over current protection circuitry 15 may include a pulse circuit 52 coupled in operative association with the balanced diode bridge 28. The pulse circuit 52 may be configured to detect a switch condition and initiate opening of the MEMS switch 20 responsive to the switch condition. As used herein, the term "switch condition" refers to a condition that triggers changing a present operating state of the MEMS switch 20. For example, the switch condition may result in changing a first closed state of the MEMS switch 20 to a second open state or a first open state of the MEMS switch 20 to a second closed state. A switch condition may occur in response to a number of actions including but not limited to a circuit fault, circuit overload, or switch ON/OFF request.

The pulse circuit 52 may include a pulse switch 54 and a pulse capacitor *C_{PULSE}* 56 series coupled to the pulse switch 54. Further, the pulse circuit may also include a pulse inductance *L_{PULSE}* 58 and a first diode *D_{P}* 60 coupled in series with the pulse switch 54. The pulse inductance *L_{PULSE}* 58, the diode *D_{P}* 60, the pulse switch 54 and the pulse capacitor *C_{PULSE}* 56 may be coupled in series to form a first branch of the pulse circuit 52, where the components of the first branch may be configured to facilitate pulse current shaping and timing. Also, reference numeral 62 is representative of a pulse circuit current *I_{PULSE}* that may flow through the pulse circuit 52.

In accordance with aspects of the present invention, the MEMS switch 20 may be rapidly switched (e.g., on the order of microseconds) from a first closed state to a second open state while carrying no current or a near zero current. This may be achieved through the combined operation of the load circuit 40, and pulse circuit 52 including the balanced diode bridge 28 coupled in parallel across contacts of the MEMS switch 20.

FIG. 6 illustrates plots of example waveforms as a function of time as may be generated as a switch is being set to the temporary open condition, in the event an over current protection circuit is utilized in a parallel circuit with the micro-electromechanical system switching circuitry. It is noted that the controller may be configured to selectively control, as the switching algorithm is executed, whether the over-current protection circuit is fired to momentarily form the electrically conductive path during any temporary open switching condition. For instance, there may be situations where such a firing may not be desirable due to voltage imbalances that may occur at the branches of the diode bridge.

It is reiterated that such over current protection circuit and corresponding pulsing technique is not a requirement for practicing aspects of the present invention since aspects of the present invention may be practiced without any such pulsing technique, or without utilization of any zero-crossing technique. Moreover, the controller may be configured to selectively control, as the switching algorithm is executed, whether the over-current protection circuit is set to momentarily form the electrically conductive path during any temporary open switching condition. Alternatively, aspects of the present invention may be practiced in combination with techniques that may (but need not) utilize both the zero-crossing and the pulsing technique.

In FIG. 6, waveform 100 represents a gating (e.g., actuating) signal applied at the gate of a switch being set to the temporary open condition. Waveform 102 represents a pulse current from the pulse circuit. Waveform 104 represents steady state load current. Time intervals I and V represent normal system operation. That is, the switch is closed and circuit load current may be at steady state. Time interval II represents initiation of a temporary switch opening and pulse firing. Time interval III represents the temporary switch opening. Time interval IV represents a return to the generally closed condition. It should be observed from the foregoing waveforms that each event associated with temporary switch opening occurs while the pulse current exists. That is, while the over-current protection circuit enables momentary formation of an electrically conductive path in parallel with the MEMS switching circuitry.

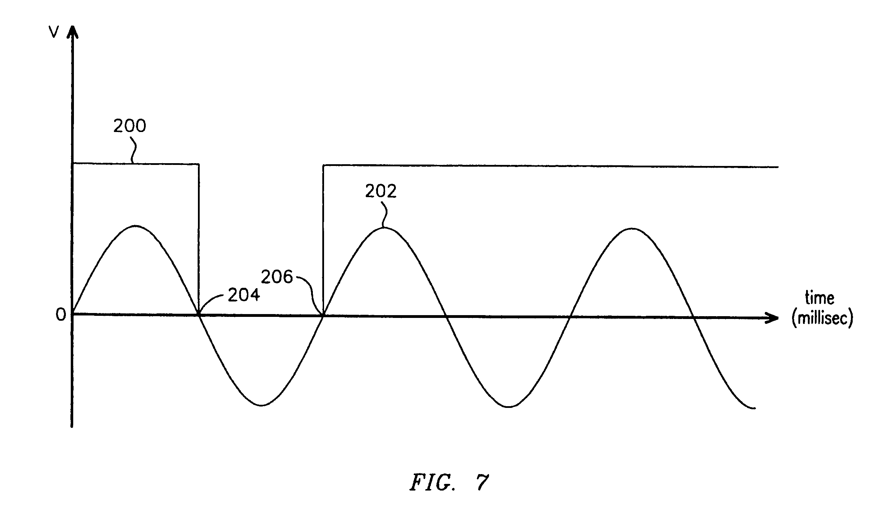

FIG. 7 illustrates plots of example waveforms as a function of time as may be generated as a switch is being set to the temporary open condition, in the event zero-crossing detection circuitry is utilized with the micro-electromechanical system switching circuitry. In FIG. 7, waveform 200 represents a gating (e.g., actuating) signal applied at the gate of a switch being set to the temporary open condition. Waveform 202 represents a voltage across the MEMS switching circuitry including zero-crossings. Note that turn-off transition 204 in synchronicity with a first zero-crossing represents initiation of the temporary switch opening. Note that turn-on transition 206 in synchronicity with a second zero-crossing represents a return to the generally closed condition.

## Claims

1. A system comprising:
micro-electromechanical system switching circuitry (12) comprising a plurality of micro-electromechanical switches (S₁ ... Sₙ), wherein said plurality of micro-electromechanical switches generally operates in a closed switching condition during system operation; and
a controller (14) coupled to the electromechanical switching circuitry (12), the controller (14) configured to actuate at least one of said micro-electromechanical switches to a temporary open switching condition while a remainder of micro-electromechanical switches remains in the closed switching condition to conduct a load circuit (50) current and avoid interrupting system operation, said temporary open switching condition of the switch useful to avoid a tendency of switch contacts to stick to one another, **characterised in that**
the controller (14) is further configured to perform a switching algorithm configured to actuate at least one distinct micro-electromechanical switch of said plurality of micro-electromechanical switches to the temporary open switching condition, wherein said at least one distinct switch comprises a switch not previously having been actuated over a predefined period of time to the temporary open switching condition, and, while actuation of said at least one distinct micro-electromechanical switch to the temporary open switching condition occurs, another remainder of the micro-electromechanical switches remains in the closed switching condition to avoid interrupting system operation.

2. The system of claim 1 wherein the controller (14) is further configured to selectively execute the switching algorithm over said predefined period of time so that eventually each of said plurality of switches is actuated at least once to the temporary open switching condition over the period of time, thereby ensuring each switch of the micro-electromechanical system switching circuitry (12) has been actuated to avoid the tendency of respective switch contacts to stick to one another.

3. The system of any of claim 1 or 2, further comprising circuitry (15) coupled to the micro-electromechanical system switching circuitry (12) to avoid current flow through the contacts of said at least one of said micro-electromechanical switches as the switch transitions to enter the temporary open switching condition from the closed switching condition.

4. The system of claim 3, further wherein said circuitry (15) is further configured to collapse a voltage level across the contacts of said at least one of said micro-electromechanical switches as the switch returns out of the temporary open switching condition to the closed switching condition.

5. The system of any of the preceding claims, further comprising circuitry (16) configured to synchronize the occurrence of the temporary open switching condition of said at least one of said micro-electromechanical switches with the occurrence of a zero crossing of at least one of the following: an alternating source voltage and an alternating load circuit current.

6. A method for actuating micro-electromechanical system switching circuitry according to claim 1, to avoid a tendency of switch contacts to stick to one another, said micro-electromechanical system switching circuitry comprising a plurality of micro-electromechanical switches, wherein said plurality of micro-electromechanical switches generally operates in a closed switching condition during system operation, the method comprising:
actuating at least one of said micro-electromechanical switches to a temporary open switching condition while a remainder of micro-electromechanical switches remains in the closed switching condition to conduct a load circuit current and avoid interrupting system operation, said temporary open switching condition of the switch useful to avoida tendecy of switch contacts to stick to one another.

7. The method of claim 6, further comprising actuating at least one distinct micro-electromechanical switch of said plurality of micro-electromechanical switches to the temporary open switching condition.

## Patentansprüche

1. System, aufweisend:
einen Schaltkreis (12) auf der Basis eines mikroelektromechanischen Systems, der mehrere mikroelektromechanische Schalter (S₁ ... Sₙ) aufweist, wobei die mehreren mikroelektromechanischen Schalter während des Systembetriebs im Wesentlichen in einem geschlossenen Schaltzustand arbeiten; und
eine mit dem elektromechanischen Schaltkreis (12) gekoppelte Steuerung (14), wobei die Steuerung (14) dafür konfiguriert ist, wenigstens einen von den mikroelektromechanischen Schaltern in einen vorübergehend offenen Schaltzustand zu versetzen, während ein Rest der mikroelektromechanischen Schalter in dem geschlossenen Schaltzustand verbleibt, um den Strom eines Lastkreises (50) zu leiten und eine Unterbrechung des Systembetriebs zu vermeiden, wobei der vorübergehend offene Schaltzustand des Schalters nützlich ist, um eine Tendenz von Schalterkontakten, aneinander haften zu bleiben, zu vermeiden **dadurch gekennzeichnet, dass**
die Steuerung (14) ferner dafür konfiguriert ist, einen Schaltalgorithmus durchzuführen, der dafür konfiguriert ist, wenigstens einen bestimmten mikroelektromechanischen Schalter von den mehreren mikroelektromechanischen Schaltern in einen vorübergehend offenen Schaltzustand zu versetzen, wobei der wenigstens eine bestimmte Schalter einen Schalter umfasst, der nicht zuvor über eine vorbestimmte Zeitdauer in den vorübergehend offenen Schaltzustand versetzt wurde, und während der Versetzung des wenigstens einen bestimmten mikroelektromechanischen Schalters in den vorübergehenden offenen Schaltzustand ein anderer Rest der mikroelektromechanischen Schalter in dem geschlossenen Schaltzustand verbleibt, um eine Unterbrechung des Systembetriebs zu vermeiden.

2. System nach Anspruch 1, wobei die Steuerung (14) ferner dafür konfiguriert ist, selektiv den Schaltalgorithmus über eine vorbestimmte Zeitdauer so auszuführen, dass schließlich jeder von den mehreren Schaltern wenigstens einmal in den vorübergehenden offenen Schaltzustand über die Zeitdauer versetzt wird, um dadurch sicherzustellen, dass jeder Schalter des Schaltkreises (12) auf der Basis des mikroelektromechanischen Systems betätigt worden ist, um die Tendenz entsprechender Schalterkontakte, aneinander haften zu bleiben, zu vermeiden.

3. System nach Anspruch 1 oder 2, das ferner einen mit dem Schaltkreis (12) auf der Basis des mikroelektromechanischen Systems gekoppelten Schaltkreis (15) aufweist, um einen Stromfluss durch die Kontakte des wenigstens einen von den mikroelektromechanischen Schaltern zu vermeiden, sobald der Schalter dazu übergeht, in den vorübergehend offenen Schaltzustand aus dem geschlossenen Schaltzustand einzutreten.

4. System nach Anspruch 3, wobei der Schaltkreis (15) ferner dafür konfiguriert ist, einen Spannungspegel über den Kontakten des wenigstens einen von den mikroelektromechanischen Schaltern zu unterdrücken, während der Schalter aus dem vorübergehend offenen Schaltzustand in den geschlossenen Schaltzustand zurückkehrt.

5. System nach einem der vorstehenden Ansprüche, das ferner eine Schaltung (16) aufweist, die dafür konfiguriert ist, das Auftreten des vorübergehend offenen Schaltzustandes des wenigstens einen von den mikroelektromechanischen Schaltern mit dem Auftreten eines Nulldurchgangs von wenigstens einem von den Nachstehenden zu synchronisieren: einer Quellenwechselspannung und einem Lastkreiswechselstrom.

6. Verfahren zum Betätigen eines Schaltkreises auf Basis eines mikroelektromechanischen Systems nach Anspruch 1, um eine Tendenz von Schalterkontakten, aneinander haften zu bleiben, zu vermeiden, wobei der Schaltkreis auf der Basis des mikroelektromechanischen Systems mehrere mikroelektromechanische Schalter aufweist, wobei die mehreren mikroelektromechanischen Schalter während des Systembetriebs im Wesentlichen in einem geschlossenen Schaltzustand arbeiten, und das Verfahren die Schritte aufweist:
Versetzen wenigstens eines von den mikroelektromechanischen Schaltern in einen vorübergehend offenen Schaltzustand, während ein Rest der mikroelektromechanischen Schalter in dem geschlossenen Schaltzustand verbleibt, um einen Lastschaltkreisstrom zu leiten und eine Unterbrechung des Systembetriebs zu vermeiden, wobei der vorübergehend offene Schaltzustand des Schalters dafür nützlich ist, eine Tendenz der Schalterkontakte, aneinander haften zu bleiben, zu vermeiden.

7. Verfahren nach Anspruch 6, ferner mit dem Schritt der Versetzung wenigstens eines bestimmten mikroelektromechanischen Schalters von den mehreren mikroelektromechanischen Schaltern in den vorübergehenden offenen Schaltzustand.

## Revendications

1. Système comprenant :
des circuits micro-électromécaniques de commutation (12) de système, comprenant une pluralité de commutateurs micro-électromécaniques (S₁ ... S₂), ladite pluralité de commutateurs micro-électromécaniques fonctionnant globalement dans un état fermé de commutation pendant le fonctionnement du système ; et
un moyen de commande (14) couplé aux circuits micro-électromécaniques de commutation (12), le moyen de commande (14) étant conçu pour mettre au moins un desdits commutateurs micro-électromécaniques dans un état temporaire ouvert de commutation tandis que le reste des commutateurs micro-électromécaniques restent dans l'état fermé de commutation pour conduire un courant de circuit de charge (50) et éviter une interruption du fonctionnement du système, ledit état temporaire ouvert de commutation du commutateur servant à éviter une tendance de contacts des commutateurs à se coller les uns contre les autres, **caractérisé en ce que**
le moyen de commande (14) est en outre conçu pour exécuter un algorithme conçu pour mettre dans l'état temporaire ouvert de commutation au moins un commutateur micro-électromécanique distinct parmi ladite pluralité de commutateurs micro-électromécaniques, ledit au moins un commutateur distinct étant constitué par un commutateur n'ayant précédemment pas été mis dans l'état temporaire ouvert de commutation au cours d'un laps de temps prédéfini et, pendant qu'a lieu la venue dudit au moins un commutateur micro-électromécanique distinct dans l'état temporaire ouvert de commutation, un autre reste des commutateurs micro-électromécaniques reste dans l'état fermé de commutation pour éviter une interruption du fonctionnement du système.

2. Système selon la revendication 1, dans lequel le moyen de commande (14) est en outre conçu pour exécuter sélectivement l'algorithme de commutation au cours dudit laps de temps prédéfini afin que, finalement, chaque commutateur de ladite pluralité de commutateurs soit mis au moins une fois dans l'état temporaire ouvert de commutation au cours du laps de temps, ce qui assure que chaque commutateur des circuits micro-électromécaniques de commutation (12) de système a été actionné pour éviter la tendance des contacts respectifs des commutateurs à se coller les uns contre les autres.

3. Système selon l'une quelconque des revendications 1 et 2, comprenant en outre des circuits (15) couplés aux circuits de commutation (12) de système micro-électromécanique pour éviter le passage de courant par les contacts dudit au moins un desdits commutateurs micro-électromécaniques lors de la période de transition durant laquelle le commutateur, en partir de l'état fermé de commutation, atteint l'état temporaire ouvert de commutation.

4. Système selon la revendication 3, dans lequel lesdits circuits (15) sont en outre conçus pour faire chuter un niveau de tension sur les contacts dudit au moins un desdits commutateurs micro-électromécaniques lorsque le commutateur repasse de l'état temporaire ouvert de commutation à l'état fermé de commutation.

5. Système selon l'une quelconque des revendications précédentes, comprenant en outre des circuits (16) conçus pour synchroniser la survenance de l'état temporaire ouvert de commutation dudit au moins un desdits commutateurs micro-électromécaniques avec la survenance d'un passage par zéro d'au moins une des grandeurs suivantes : tension alternative de source et intensité alternative de circuit de charge.

6. Procédé pour actionner des circuits micro-électromécaniques de commutation de système selon la revendication 1 afin d'éviter une tendance des contacts des commutateurs à se coller les uns contre les autres, lesdits circuits de commutation de système micro-électromécanique comprenant une pluralité de commutateurs micro-électromécaniques, ladite pluralité de commutateurs micro-électromécaniques fonctionnant globalement dans un état fermé de commutation pendant le fonctionnement du système, le procédé comprenant :
la mise d'au moins un desdits commutateurs micro-électromécaniques dans un état temporaire ouvert de commutation tandis que le reste des commutateurs micro-électromécaniques restent dans l'état fermé de commutation pour conduire un courant de circuit de charge et éviter une interruption du fonctionnement du système, ledit état temporaire ouvert de commutation du commutateur servant à éviter une tendance de contacts des commutateurs à se coller les uns contre les autres.

7. Procédé selon la revendication 6, comprenant en outre la mise dans l'état temporaire ouvert de commutation d'au moins un commutateur micro-électromécanique distinct parmi ladite pluralité de commutateurs micro-électromécaniques.
